# EUROPEAN PATENT APPLICATION

(11) **EP 2 682 498 A2**
(43) Date of publication of application: **08.01.2014**
(21) Application number: 12751958.5
(22) Date of filing: 28.02.2012
(51) Int. Cl.: C23C 14/34, C23C 14/35, C23C 14/46

(54) **METHOD FOR MANUFACTURING RAZOR BLADE EDGE AND RAZOR BLADE FOR RAZOR**

(30) Priority: 28.02.2011 KR 20110018118
(71) Applicant: Dorco Co., Ltd, Yongin-si, Gyeonggi-do 449-923 (KR)
(72) Inventor: JEONG, Sung Won, Ansan-si Gyeonggi-do 426-788 (KR)
(74) Representative: Mittler, Enrico
(86) International application number: PCT/KR2012/001472
(87) International publication number: WO 2012/118313

(57) **Abstract**

The present invention relates to a method for manufacturing a razor blade edge and a razor blade for a razor, and more specifically, to a method for manufacturing razor blade edge of a razor blade provided with a light complex thin film having metallic and ceramic properties for improving durability and hardness. According to the present invention, the method comprises: a first step of heat-treating stainless steel; a second step of forming the razor blade edge by polishing the heat-treated stainless steel; and a third step of depositing a plurality of coating materials on the razor blade edge that is formed, wherein a sputtering device is used in the third step, the sputtering device being provided with a sputter target, and the sputtering target comprising a first ingredient and a second ingredient which are deposited on the razor blade edge and on the razor blade. (Fig. 3)

## Description

### Cross-Reference To Related Application

This application claims the benefit of Korean Patent Application No. 10-2011-0018118, filed on February 28, 2011 in the Korean Intellectual Property Office, the disclosure of which is incorporated herein by reference.

### Technical Field

The present invention relates to a method of manufacturing a razor blade edge and a razor blade of a razor, and more particularly, to a method of manufacturing a razor blade edge and a razor blade of a razor that have a hard complex thin film simultaneously having a metallic characteristic and a ceramic characteristic for improving durability and hardness in the razor blade edge and the razor blade.

### Background Art

A razor blade of a wet type razor is generally formed using a base material such as a stainless steel. Particularly, in the base material such as a stainless steel, in order to increase hardness of the razor blade, a heat treatment process is performed, and then in order to form a razor blade edge, a grinding process is performed. Thereafter, a process of depositing various coating materials on an edge of a final razor blade is performed.

In this case, in order to increase strength and durability of a razor blade, the coating material may be used in a thin film of a metal-based or ceramic-based carbide, nitride, and oxide, which are a general hard thin film material. Further, after the hard thin film material is coated at the razor blade, when a user shaves, the hard thin film material decreases a friction with a skin, and in order to improve a shaving performance, an organic material of PolyTetraFluoroEthylene (hereinafter, referred to as 'PTFE') may be deposited. However, there was a problem that adhesive strength between the hard thin film materials and an organic material such as the PTFE is not good. Therefore, in order to increase adhesive strength between the razor blade and the hard thin film and an organic material such as the PTFE, a metal thin film of Chromium (Cr), Titanium (Ti), Tungsten (W), and Niobium (Nb) may be deposited between the PTFE and the hard thin film.

The hard thin film generally performs a function of improving durability, corrosion resistance and strength of a razor blade, and a material that provides very excellent strength such as a Chromium (Cr)-Platinium (Pt) alloy is generally deposited at the razor blade. That is, by coating a hard thin film, for example, Cr-Pt, DLC, CrN, TiN, and TiAlN at a razor blade edge and a razor blade, abrasion resistance and hardness are improved and thus durability is improved. In more detail, in order to deposit the material at the razor blade, for example, a physical vapor deposition method using each target of Cr and Pt is used.

When depositing a hard thin film at the razor blade edge and the razor blade with a physical vapor deposition method, a method of rotating the razor blade or a target using two targets and of stacking two materials in a stacking structure is used. In this case, because enough space is necessary within a deposition chamber, the hard thin film cannot be deposited at small and narrow space. Further, in this case, it is difficult that characteristics of two targets, i.e., two materials simultaneously represent and an enough time in representing the characteristics is required. That is, a limitation exists in a deposition method of using an existing target, i.e., two targets for depositing such a hard thin film.

Further, when two materials use a compound, a mixture, or a target coupled to a crystal, it is very difficult to adjust a characteristic component ratio of two materials. Accordingly, because a case in which a component different from that of the two materials is deposited occurs, when depositing a coating material, i.e., when depositing a hard thin film, a limitation exists.

### Disclosure

### Technical Problem

The present invention has been made in view of the above problems, and provides a method of depositing a thin film of two components in a single target when depositing a Cr-DLC-based hard thin film with the single target using a physical vapor deposition method.

The present invention further provides a method of depositing a thin film in which two components together exist using an existing compound, mixture, or a target coupled to a crystal and a single target that does not uses each of Cr and DLC targets when depositing a Cr-DLC-based hard thin film simultaneously having a characteristic of two components at a razor blade using a physical vapor deposition method and when depositing the hard thin film at the razor blade.

### Technical Solution

In accordance with an aspect of the present invention, there is provided a method of manufacturing a razor blade edge and a razor blade of a razor, the method including: a first process of performing a heating treatment of a stainless steel; a second process of forming a razor blade edge by grinding the stainless steel in which a heating treatment is performed; and a third process of depositing a plurality of coating materials on the formed razor blade edge, wherein in the third process, a sputtering apparatus is used, but a sputter target is provided in the sputtering apparatus, and the sputter target includes a first component and a second component deposited at the razor blade edge and the razor blade.

### Advantageous effects

As described above, according to the present invention, by simultaneously depositing two components of thin films at a razor blade in a single target, a time consumed in depositing a hard thin film in the razor blade can be shortened. Further, a target or a razor blade can be used at small and narrow space without a rotation. A component ratio of a material deposited at a surface area of two components within the target can be adjusted.

### Brief Description of Drawings

FIG. 1 is a conceptual diagram illustrating a sputter target of a sputtering apparatus, which is a kind of a physical vapor deposition method using for embodying a method according to an exemplary embodiment of the present invention;
FIG. 2 is a top plan view illustrating a sputtering apparatus for depositing a hard thin film at a razor blade and a razor blade edge using a sputter target according to an exemplary embodiment of the present invention; and
FIG. 3 is a diagram illustrating a deposition principle of a razor blade edge in a deposition process according to an exemplary embodiment of the present invention.

### <Description of reference numeral>

100: sputter target 102: metal material
104: ceramic material 200: sputtering apparatus
206: razor blade 208: sputter target
300: razor blade 302,304: target

### Best modes for carrying out the invention

Hereinafter, exemplary embodiments of the present invention are described in detail with reference to the accompanying drawings.

Detailed descriptions of well-known functions and structures incorporated herein may be omitted to avoid obscuring the subject matter of the present invention. Hereinafter, the present invention is described in detail with reference to the accompanying drawings.

In an exemplary embodiment of the present invention, a method of depositing using a Cr-DLC-based hard thin film having a thickness T of 0<T≤200nm and formed in a structure of a Cr-DLC-based hard thin film, for example a thin film having a crystalline or amorphous characteristic coated, i.e., deposited on a razor blade edge and a razor blade using a physical vapor deposition (hereinafter, referred to as 'PVD') method will be described.

Before describing the present invention, the PVD method may be any one random method of DC sputter, DC magnetron sputter, DC unbalanced magnetron sputter, pulse DC unbalanced magnetron sputter, radio frequency (RF) sputter, arc ion plating, electron-beam deposition, ion-beam deposition, and ion-beam assisted deposition methods.

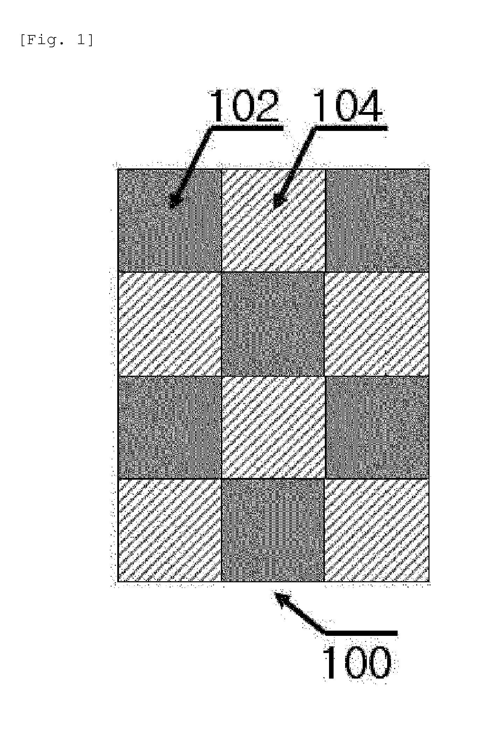

FIG. 1 is a conceptual diagram illustrating a sputter target of a sputtering apparatus, which is a kind of a physical vapor deposition method using for embodying a method according to an exemplary embodiment of the present invention.

Referring to FIG. 1, a sputter target 100 is divided into a plurality of areas, and two components to deposit to a razor blade are included in the plurality of areas.

In a first area of the sputter target 100, a first component, for example, a metal-based material (hereinafter, referred to as a 'metal material') 102 is included, and in a second area, a second component, for example, a ceramic-based material (hereinafter, referred to as a 'ceramic material') 104 is included. Further, the metal material 102 improve strength of the razor blade and improves adhesive strength of an organic material with the razor blade and the razor blade edge. The ceramic material 104 increases durability by increasing corrosion resistance and hardness. For example, the metal material 102 of the first area includes Cr, Ti, W, and Nb, and the ceramic material 104 of the second area includes carbon. Shapes of the metal material 102 and the ceramic material 104, which are materials within the sputter target 100 may become any one shape of a polygon such as a circle, a triangle, and a quadrangle, and this may be changed, as needed.

In the foregoing description, a shape of a material is a shape of a second component that inserts into or bonds to the sputter target 100 of each area, for example, a first component of the sputter target 100.

Further, in the first area, the second component may be included, and in the second area, the first component may be included.

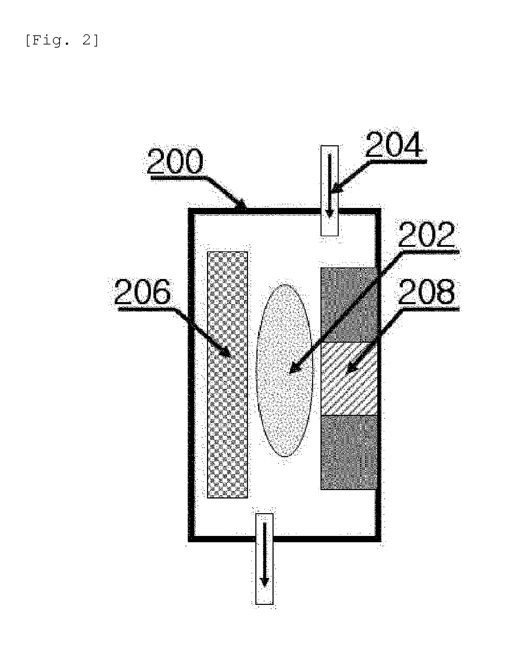

Hereinafter, a sputtering apparatus according to an exemplary embodiment of the present invention will be described with reference to FIG. 2.

FIG. 2 is a top plan view illustrating a sputtering apparatus for depositing a hard thin film at a razor blade and a razor blade edge using a sputter target according to an exemplary embodiment of the present invention.

Referring to FIG. 2, in a sputtering apparatus 200, a sputter target 208 and a razor blade 206 are mounted. The sputtering apparatus 200 is formed in a hexahedral shape or a cylindrical shape and may be changed in different forms, as needed. Further, a vacuum is formed within the sputtering apparatus 200, and an atmosphere and plasma 202 may be formed by an injection gas 204. The razor blade 206 and the sputter target 208 are disposed to face, and the sputter target 208 may be a fixed type or a movable type. Further, the razor blade 206 may be also a fixed type or a movable type.

First, in the sputtering apparatus 200, the sputter target 208 is mounted. In order to deposit a thin film by the sputter target 208, the razor blade 206 is mounted in the sputtering apparatus 200. When the razor blade 206 is mounted in the sputtering apparatus 200, the sputtering apparatus 200 becomes a high vacuum state.

Next, an argon (Ar) gas is injected into the sputtering apparatus 200, and DC power is applied. Accordingly, an Ar gas within the sputtering apparatus 200 becomes plasma, and Ar ions are generated. The generated Ar ions collide with the sputter target 208, and the sputter target 208, having collided with the Ar ions become an atom and emit the two components.

In this case, DC power of a negative electrode (-) is applied to the razor blade 206, and emitted atoms, i.e., two components of the sputter target 208 are deposited at the razor blade 206.

In the sputtering apparatus, an ion gun may be additionally installed. Further, by together using the stuttering apparatus and an arc ion plating method, a thin film deposition process through the sputter target may be performed.

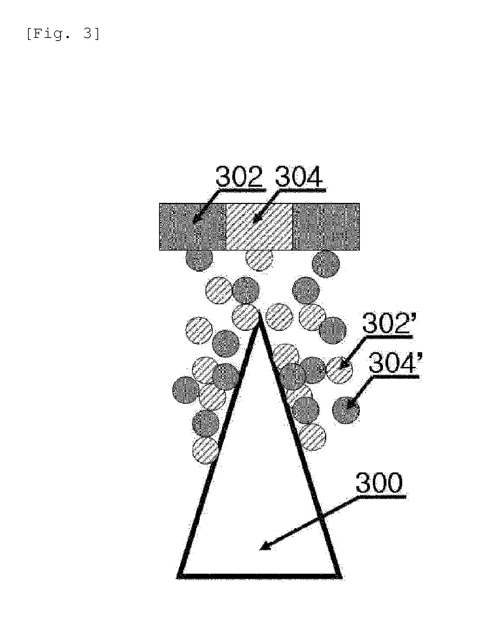

Hereinafter, a cross-sectional view of a razor blade edge will be described with reference to FIG. 3.

FIG. 3 is a diagram illustrating a deposition principle of a razor blade edge in a deposition process according to an exemplary embodiment of the present invention.

Referring to FIG. 3, a razor blade 300 is formed using a base material such as a stainless steel, and in order to increase hardness of the razor blade 300, a heat treatment process is performed, and then a process of grinding for forming a razor blade edge is performed.

An injection gas, for example an Ar gas becomes plasma and thus becomes an Ar ion according to a deposition principle of the sputtering apparatus shown in FIG. 2. When the Ar ions collide with the sputter target, target materials become atoms 302' and 304' and are separated by energy according to a collision. The atomized target materials are adhered to the razor blade 300 and thus the same material as that of targets 302 and 304 is simultaneously deposited at the razor blade 300.

By rotating or fixing one of the razor blade 300 or the sputter target by such a principle, a thin film may be deposited to together have characteristics of two targets 302 and 304. Further, in this case, a thin film having a crystalline or amorphous characteristic may be deposited at small space at a short time, compared with a conventional case, and characteristics of a metallic material and a ceramic material of a non-stacking single structure are together mixed and thin films having the characteristics may be formed in a deposited thin film.

By adjusting a ratio of a metal-based material and a ceramic-based material included in the sputter target, i.e., a ratio of a surface area in which the materials are included, a ratio of a metal-based material and a ceramic-based material, which are a component of a deposited thin film can be easily adjusted. Further, the thin film can acquire a crystalline characteristic or an amorphous characteristic according to this ratio. Further, a thickness of a necessary thin film can be easily controlled through a deposition time and electric energy applied to the sputter target.
1. After the razor blade is mounted in the sputtering apparatus, a chamber maintains an initial vacuum degree of 10⁻⁶torr.
2. In order to remove an oxide film and a remaining foreign substance of the razor blade, an etching process by Ar plasma is performed.
3. A deposition process is performed using Cr and C targets. In order to wash the target, pre-sputtering is performed in an Ar atmosphere for about 5 to 20 seconds.
4. In order to well adhere materials separated from the target and to be deposited to a razor blade, a voltage of -300V to -600V is applied.
5. DC power of about 3 kW to 6 kW is applied to the sputter target. A thickness of a thin film to be deposited is set to about 100nm to 300 nm.

Hereinafter, a cutting force of a razor blade according to a thin film will be described with reference to Table 1.

**[Table 1]**

| Evaluation method | When comparing with Cr thin film | When comparing with CrN thin film |
|---|---|---|
| Cutting performance | -5.74% | +5.15% |
| Cutting performance | -9.80% | +6.36% |
| Corrosion resistance | +16.54% | +21.27% |
| Abrasion resistance | -1.31% | +2.23% |
| Durability | +28.83% | +8.66% |
| Total evaluation | +12.44% | +8.73% |

Table 1 compares and analyzes a razor blade in which a Cr-DLC thin film is deposited and a razor blade in which an existing Cr or CrN thin film is deposited.

First, when shaving using a base material for cutting, a most important cutting performance and cutting performance were measured. Next, corrosion resistance characteristics were compared, and abrasion resistance and durability were compared using a base material for cutting. As an entire comparison result, in durability and abrasion resistance, a razor blade in which a Cr-DLC thin film is deposited represented more excellent performance than a razor blade in which an existing Cr or CrN thin film is deposited. Further, compared with a razor blade in which a CrN thin film is deposited, it can be seen that a cutting performance and a cutting performance are increased.

Further, in order to compare a razor blade in which the CrN thin film is deposited and a razor blade in which an existing Cr and CrN thin film is deposited, by applying razor blades to an actual razor cartridge, a kind of a razor blade was not notified to users and when shaving, a performance was evaluated. As a result, it was evaluated that the razor blade in which the Cr-DLC thin film is deposited is entirely more excellent in comfort, close contact, whether a cut occurs in a skin, and an impression after shaving than an existing razor blade, i.e., a razor blade in which a Cr or CrN thin film is deposited.

## Claims

1. A method of manufacturing a razor blade edge and a razor blade of a razor, the method comprising:
a first process of performing a heating treatment of a stainless steel;
a second process of forming a razor blade edge by grinding the stainless steel in which a heating treatment is performed; and
a third process of depositing a plurality of coating materials on the formed razor blade edge,
wherein in the third process, a sputtering apparatus is used, but a sputter target is provided in the sputtering apparatus, and the sputter target comprises a first component and a second component deposited at the razor blade edge and the razor blade.

2. The method of claim 1, wherein the third process comprises depositing a metal thin film or a ceramic-based carbide, nitride, and oxide thin film at the razor blade.

3. The method of claim 1, wherein the metal thin film comprises any one of Cr, Ti, W, and Nb.

4. The method of claim 1, wherein the third process further comprises depositing PolyTetraFluoroEthylene (PTFE), which is an organic material at the razor blade.

5. The method of claim 1, wherein the third process further comprises depositing a metal thin film between a thin film of a hard material and an organic material.

6. The method of claim 1, wherein the first component is a metal-based material.

7. The method of claim 6, wherein the metal-based material is formed in a circular or polygonal shape.

8. The method of claim 6, wherein the metal-based material is any one of Cr, Ti, W, and Nb.

9. The method of claim 1, wherein the first component is a ceramic-based material.

10. The method of claim 9, wherein the ceramic-based material is formed in a circular or polygonal shape.

11. The method of claim 9, wherein the ceramic-based material is carbon.

12. The method of claim 1, wherein the second component is a metal-based material.

13. The method of claim 12, wherein the metal-based material is formed in a circular or polygonal shape.

14. The method of claim 1, wherein the second component is a ceramic-based material.

15. The method of claim 14, wherein the ceramic-based material is formed in a circular or polygonal shape.

16. The method of claim 1, wherein the sputtering apparatus is formed in a hexahedral form or a cylindrical form.

17. The method of claim 1, wherein in the sputtering apparatus, a vacuum is formed.

18. The method of claim 1, wherein the third process comprises:
injecting a gas into the sputtering apparatus; and
forming an atmosphere and plasma through the injected gas.

19. The method of claim 1, wherein in the third process, the razor blade and the sputter target are disposed to face, and the razor blade or the sputter target is formed in a fixed type or a movable type.

20. The method of claim 1, wherein in the third process, an ion gun is additionally installed and used in the sputtering apparatus.

21. The method of claim 1, wherein in the third process, the sputtering apparatus and an arc ion plating method are together used.
